# EUROPEAN PATENT SPECIFICATION

(11) **EP 2 393 202 B1**
(45) Date of publication and mention of the grant of the patent: **15.10.2014**
(21) Application number: 10164762.6
(22) Date of filing: 02.06.2010
(51) Int. Cl.: H03F 3/217, H03F 3/68

(54) **Three-way audio driver and a method for producing a three-way audio drive signal**
Dreiweg-Audiotreiber und Verfahren zur Herstellung eines Dreiweg-Audioantriebssignals
Circuit de commande audio à trois voies et procédé de production d'un signal de commande audio à trois voies

(43) Date of publication of application: 07.12.2011
(73) Proprietor: Dialog Semiconductor B.V., 5215 MV 's-Hertogenbosch (NL)
(72) Inventor: Kruiskamp, Marinus Wilhelmus, 5237 CB 's-Hertogenbosch (NL); Lubberhuizen, Wessel Harm, 7491 LB Delden (NL)
(74) Representative: Nederlandsch Octrooibureau

(56) References cited:
- US-A1- 2008 019 546
- US-A1- 2008 111 624
- US-B1- 6 552 607
- US-B1- 7 010 131

## Description

### Field of the invention

The present invention relates to a three-way audio driver and a method of generating a three-way audio drive signal.

### Background of the invention

There are a lot of (portable) devices with a stereo audio output (e.g. mp3 player, telephone, radio receiver and laptop, desktop computer, television set etc.), where the stereo audio output is arranged to be connected to speakers, such as a headphone, by means of an audio driver comprising a socket and an audio connector comprising a plug, where the audio connector can be connected to the audio driver by connecting the plug to the socket.

For audio drivers it is important to be compatible with existing audio connectors. Especially for portable devices, it is important that the audio driver has a relatively low power consumption and has a small size.

Audio drivers and audio connectors are know that are arranged to transmit three signals, such as for instance a left-hand signal, a right-hand signal and a common signal. Such audio drivers will be referred to in this text as three-way audio drivers and three-way audio connectors.

An example of such a three-way audio connector is a TRS-connector (Tip, Ring, Sleeve), also referred to as an audio jack, phone plug, mini-stereo or headphone jack. The TRS-connector is cylindrical in shape and has typically three contacts, although connectors with two contacts (a TS connector) or four contacts (a TRRS connector) are also known.

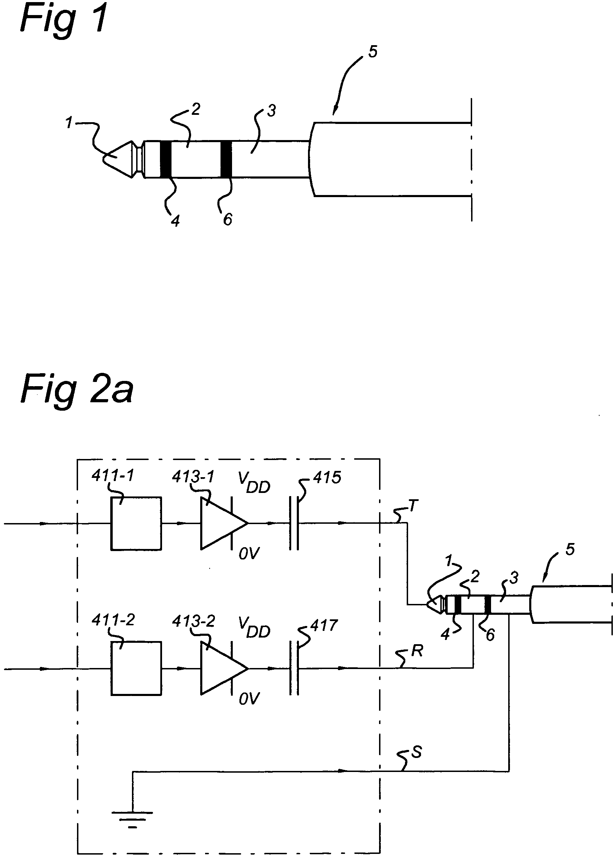

An example of a TRS-connector 5 is schematically shown in Fig. 1.

The TRS-connector 5 as shown in Fig. 1 comprises a first connector 1, a second connector 2 and a third connector 3.

The first connector 1 may be formed by a tip of the TRS-connector 5 and may be referred to as the tip. The first connector 1 may for instance be used for the left-hand channel signal.

The second connector 2 may be formed by a mid part of the TRS-connector 5 and may be referred to as the ring. The second connector 2 may for instance be used for the right-hand channel signal.

The third connector 3 may be formed by a sleeve part of the TRS-connector 5 and may be referred to as the sleeve. The third connector 3 may for instance be used for a common signal, usually ground.

Normally the TRS-connector 5 comprises one or more insulating rings 4,6 , wherein a first insulating ring 4 may be located in between the first connector 1 and the second connector 2, and a second insulating ring 6 may be located in between the second connector 2 and the third connector 3.

Different three-way audio drivers are known that are arranged to drive three-way audio connectors, such as the TRS-connector 5 described above.

Since the TRS connector 5 as described here has the third (sleeve) connector 3 for the common ground, it is not suitable for all kind of stereo drivers.

Many three-way audio drivers and three-way audio connectors are known in the prior art. For instance, three-way audio drivers are known which comprise switching amplifiers, which are also known as class-D amplifiers. Such switching amplifiers are efficient and can theoretically approach an efficiency of 100%.

Switching amplifiers are for instance widely used as hands-free speaker drivers in mobile and cordless telephones. The continuous request for longer battery lifetime of portable audio devices makes it attractive to use switching amplifiers also as headphone drivers.

The principle of a switching amplifier is that the output is connected by switches to either ground or to a voltage supply. For each switch, the voltage or the current is very small. This results in very low power dissipation in the switches. Theoretically the efficiency can reach 100% and is independent from the signal amplitude. In practice the efficiency will be a bit lower due to for instance switching losses, but switching amplifiers are still very efficient compared to other types of amplifiers. The switching scheme of class-D amplifiers can be implemented by either PWM (pulse-width modulation) or sigma-delta based circuitry (for instance as part of PDM (pulse-density modulation)).

Next a few prior art class-D audio drivers will be described with reference to Fig.'s 2a - 2c.

Fig. 2a schematically shows a three-way audio driver that is compatible with a three-way audio connector 5.

The three-way audio driver comprises a first and a second converter 411-1, 411-2 and a first and a second amplifier 413-1, 413-2. The first converter 411-1 and amplifier 413-1 together form a first switching amplifier. The second converter 411-2 and amplifier 413-2 together form a second switching amplifier.

The first and second converters 411-1, 411-2 may be provided by any suitable converter, such as a sigma-delta convertor or a Pulse Width Modulator.

The first switching amplifier is arranged to receive a first input signal, for instance a digital or analogue signal, representing a first audio signal, for instance a right hand side audio signal of a stereo audio signal. The first switching amplifier is arranged to output a first amplified digital signal which varies between 0 Volt and V_{DD} Volt.

The second switching amplifier is arranged to receive a second input signal, for instance a digital or analogue signal, representing a second audio signal, for instance a left hand side audio signal of a stereo audio signal. The second switching amplifier is arranged to output a second amplified digital signal which varies between 0 Volt and V_{DD} Volt.

The first amplified digital signal is provided to the first connector 1 of the three-way audio connector 5 via a DC-blocking capacitor 415. The second amplified digital signal is provided to the second connector 2 of the three-way audio connector 5 via a DC-blocking capacitor 417. The function of the DC-blocking capacitors 415, 417 is to provide DC-biasing of the first and second amplified digital signals. A common ground signal is provided to the third connector 3 of the three-way audio connector 5.

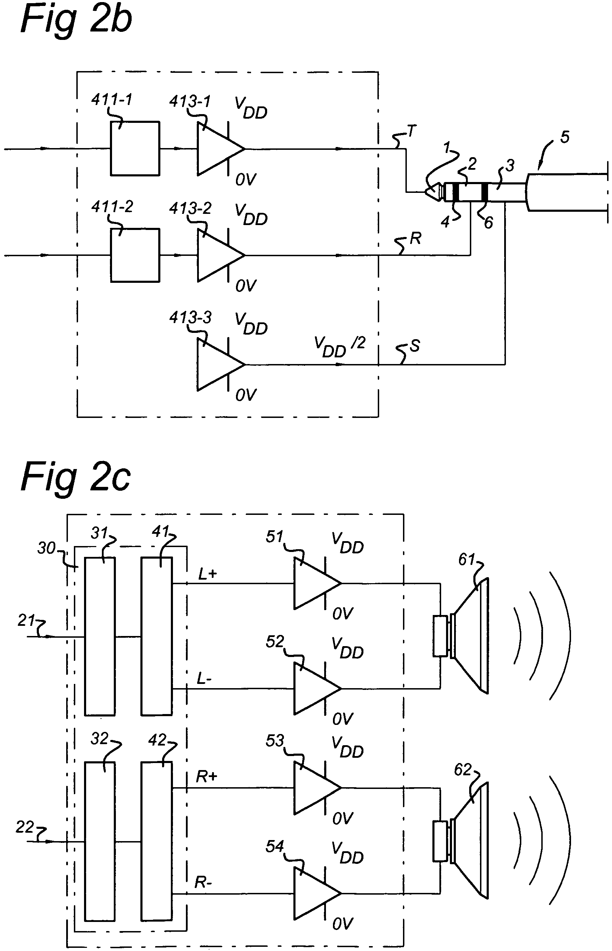

Fig. 2b schematically depicts an alternative solution. Instead of providing two DC-blocking capacitors, the first and second amplified digital signals are directly connected to the first connector 1 and second connector 2 of the three-way audio connector 5 respectively. The first and second amplified digital signals vary between 0 Volt and VDD Volt. So, to eliminate the DC-component, a buffered version of the half-supply may be supplied to the third connector 3, which may have a value of V_{DD}/2. This signal may be created using a third amplifier 413-3. This arrangement however has a relatively low efficiency.

A further known solution is schematically depicted in Fig. 2c. The example shown in Fig. 2c schematically shows class-D amplifiers in a Bridge-Tied-Load configuration. This provides a relatively high efficiency on a relatively small circuit board area.

Fig. 2c schematically depicts a four-way driving circuit 30. The four-way driving circuit 30 may be a sigma-delta convertor or a Pulse-Width-Modulator. The four-way driving circuit 30 may for instance comprise a first loop filter 31 and a first quantizer 41 and further a second loop filter 32 and a second quantizer 42.

The first loop filter 31 and the first quantizer 41 are arranged to process the first input signal 21 to a L+ signal and a L- signal, forming the two components of the right hand signal. Next, the L+ and L- signals are amplified by first and second amplifier 51, 52 respectively. As the L+ and L- signals are digital signals, the first and second amplifiers 51, 52 function as a switching amplifier.

The second loop filter 32 and the second quantizer 42 are arranged to process the second input signal 22 to a R+ signal and a R- signal, forming the two components of the right hand signal. Next, the R+ and R- signals are amplified by third and fourth amplifier 53, 54 respectively. As the R+ and R- signals are digital signals, the third and fourth amplifiers 53, 54 function as a switching amplifier.

The outputs of the first to fourth amplifiers 51 ― 54 can be directly coupled to a set of speakers 61, 62. This however requires two dedicated connections per speaker as depicted in figure 2c. It is therefore not compatible with a three-way connector, such as shown in Fig. 1.

A time division multiplexed PWM amplifier with 4-to-3 line encoding is taught in US6552607.

### Summary of the invention

The object of the invention is to use a new switching scheme for a stereo class-D driver that allows the driver to be connected to a headphone with a standard three-way audio connector (e.g. of the tip, ring, sleeve type) without the need of large DC-blocking capacitors.

This object is obtained by a three-way audio driver arranged to produce a three-way drive signal for driving a first and a second speaker in response to an input signal, the three-way audio driver being arranged to generate a first three-way drive signal component for a first input of the first speaker, a second three-way drive signal component for a first input of the second speaker, and a third three-way drive signal component for a second input of the first speaker and a second input of the second speaker, characterized in that the three-way audio driver comprises a four-way driving circuit and a converter, the four-way driving circuit being arranged to generate a four-way drive signal and the converter being arranged to receive the four-way drive signal and convert the four-way drive signal into a three-way drive signal. By providing such a driver, the advantages of a four-way driver can be applied in a three-way driver.

The convertor is arranged as follows:
- in case the four-way drive signal L+, L-, R+, R- equals 0, 1, 1, 0, a three-way drive signal R, T, S is generated which equals 0, 1, x, and
- in case the four-way drive signal L+, L-, R+, R- equals 1, 0, 0, 1 a three-way drive signal R, T, S is generated which equals 1, 0, x,
wherein the convertor is further arranged to execute a decision algorithm to determine the value of x.

By applying a decision algorithm, missing code situations can be resolved.

According to an embodiment there is provided three-way audio driver wherein the four-way driver is provided by a bridge-tied-load configuration. The bridge-tied-load configuration may comprise a sigma-delta convertor or a PWM-modulator. According to an example, the four-way driver may comprise a first and second loop filter and a first and second quantizer, as already described above with reference to Fig. 2c.

According to an embodiment there is provided a three-way audio driver wherein the four-way drive signal is a binary signal comprising
- a first four-way drive signal component for the first input of the first speaker,
- a second four-way drive signal component for the second input of the first speaker,
- a third -way drive signal component for the first input of the second speaker, and
- a fourth four-way drive signal component for the second input of the second speaker.

According to an embodiment there is provided a three-way audio driver wherein the three-way drive signal components are binary signals.

According to an embodiment there is provided a three-way audio driver wherein for a group of combinations of four-way drive signals:
- a difference between the first three-way drive signal and the third three-way drive signal is an indication of a difference between the first four-way drive signal and the second four-way drive signal, and wherein
- a difference between the second three-way drive signal and the third three-way drive signal, is an indication of a difference between the third four-way drive signal and the fourth four-way drive signal.

It will be understood that the above can only apply for a number of combinations of four-way drive signals, but not to all combinations of four-way drive signals, as more information can be encoded in four signals than in three signals. So, a group of combinations of four-way drive signals can be defined for which decode into three-way drive―signals is possible.

As is clear from the examples provided, there is also a further group of combinations of four-way drive signals for which it is not possible to generate a proper three-way drive signal. From the example provided here, the further group comprises the following four-way drive signals L+, L-,R+, R- : 0, 1, 1, 0 and 1, 0, 0, 1.

According to an embodiment there is provided a three-way audio-driver, wherein the converter uses a conversion table, such as:

| **Four way drive signal** | **Three way drive signal** |
|---|---|
| 0 1 0 1 | 0 0 1 |
| 0 1 0 0 | 0 1 1 |
| 0 1 1 0 | 0 1 x (missing code) |
| 0 0 0 1 | 1 0 1 |
| 0 0 0 0 | 0 0 0 or 1 1 1 |
| 0 0 1 0 | 0 1 0 |
| 1 0 0 1 | 1 0 x (missing code) |
| 1 0 0 0 | 1 0 0 |
| 1 0 1 0 | 1 1 0 |

This is an advantageous way of programming a converter.

According to an embodiment there is provided three-way audio driver, wherein the converter is arranged to time-multiplex the three-way drive signals such that each combination of four-way drive signals is converted into two subsequent combinations of three-way drive signals during a first time frame and a second time frame,
wherein during the first time frame:
- a difference between the first three-way drive signal and the third three-way drive signal is an indication of a difference between the first four-way drive signal and the second four-way drive signal, and
- a difference between the second three-way drive signal and the third three-way drive signal is substantially zero,
and wherein during the second time frame,
- a difference between the first three-way drive signal and the third three-way drive signal is substantially zero, and
- a difference between the second three-way drive signal and the third three-way drive signal is an indication of a difference between the third four-way drive signal and the fourth four-way drive signal.

By using a time-multiplexed three-way drive signal, more information can be comprised in the three-way drive signal, allowing conversion of a four-way into a three-way drive signal.

>

According to an embodiment there is provided a three-way audio driver wherein the decision algorithm is arranged to determine the value of x by copying a previous value of the third three-way drive signal component. This is a relatively simple and straightforward way of solving missing code situations.

According to an embodiment there is provided a three-way audio driver wherein the four-way driving circuit comprises a first and second loop filter associated with a first and second channel, the first loop filter being arranged to generate a first output and the second loop filter being arranged to generate a second output, whereby the decision algorithm is arranged to determine which one of the first and second output has the highest absolute value and to determine the value of x in accordance with the channel corresponding with the highest output.

According to an embodiment there is provided a three-way audio driver wherein the decision algorithm is arranged to determine the value of x such that alternatively:
- a difference between the first three-way drive signal and the third three-way drive signal is an indication of a difference between the first four-way drive signal and the second four-way drive signal, and
- a difference between the second three-way drive signal and the third three-way drive signal, is an indication of a difference between the third four-way drive signal and the fourth four-way drive signal.

This is again a relatively simple and straightforward way of solving missing code situations.

According to a further aspect there is provided a method of generating a three-way audio drive signal for driving a first and a second speaker in response to an input signal, the method comprising:
a) receiving an input signal,
b) generating a four-way drive signal based on the received input signal,
c) converting the generated four-way drive signal into a three-way drive signal
comprising a first three-way drive signal component for a first input of the first speaker, a second three-way drive signal component for a first input of the second speaker, and a third three-way drive signal component for a second input of the first speaker and a second input of the second speaker.

According to the invention, step c) comprises:
- in case the four-way drive signal L+, L-, R+, R- equals 0, 1, 1, 0, a three-way drive signal R, T, S is generated which equals 0, 1, x, and
- in case the four-way drive signal L+, L-, R+, R- equals 1, 0, 0, 1 a three-way drive signal R, T, S is generated which equals 1, 0, x, and executing a decision algorithm to determine the value of x.

According to an embodiment there is provided a method wherein c) further comprising generating a time-multiplexed three-way drive signal, such that each combination of four-way drive signals is converted into two subsequent combinations of three-way drive signals during a first time frame and a second time frame, wherein during the first time frame:
- a difference between the first three-way drive signal and the third three-way drive signal is an indication of a difference between the first four-way drive signal and the second four-way drive signal, and
- a difference between the second three-way drive signal and the third three-way drive signal is substantially zero,
   and wherein during the second time frame,
- a difference between the first three-way drive signal and the third three-way drive signal is substantially zero, and
- a difference between the second three-way drive signal and the third three-way drive signal is an indication of a difference between the third four-way drive signal and the fourth four-way drive signal.

According to an embodiment there is provided a method, wherein the decision algorithm determines the value of x by copying a previous value of the third three-way drive signal component.

According to an embodiment there is provided a method, wherein the decision algorithm determines the value of x by
- determining an absolute value of a first output of a first loop filter associated with a first channel,
- determining an absolute value of a second output of a second loop filter associated with a second channel,
- determining which one of the first output and the second output has the highest absolute value,
- determine the value of x in accordance with the channel corresponding with the highest output.

According to an embodiment there is provided a method, wherein the decision algorithm determines the value of x such that alternatively:
- a difference between the first three-way drive signal and the third three-way drive signal is an indication of a difference between the first four-way drive signal and the second four-way drive signal, and
- a difference between the second three-way drive signal and the third three-way drive signal, is an indication of a difference between the third four-way drive signal and the fourth four-way drive signal.

According to an aspect there is provided a computer program product comprising data and instructions that can be loaded by a computer device, allowing said computer device to perform any of the methods described above.

According to an aspect there is provided a computer readable medium provided with such a computer program product.

According to an aspect there is provided a computer device arranged to perform any one of the methods described above.

### Brief description of the drawings

The invention will be explained in detail with reference to some drawings that are only intended to show embodiments of the invention and not to limit the scope. The scope of the invention is defined in the annexed claims and by its technical equivalents:
Figure 1 schematically shows an example of a three-way connector.
Figures 2a - 2c schematically show examples of a class-D drivers according to the state of the art, and
Fig's 3 and 4 schematically show different embodiments.

### Detailed description of embodiments

The embodiments provide a solution to use class-D amplifiers in a Bridge-Tied-Load configuration in combination with a 3-way audio connector 5.

The embodiments provide a conversion of the four binary signals (L+, L-, R+, R-) from a stereo bridge-tied-load class-D configuration into three binary signals (e.g. for a tip, ring and sleeve) that can be connected to a 3-way audio connector, such as a three-way audio connector 5 as shown in Fig. 1.

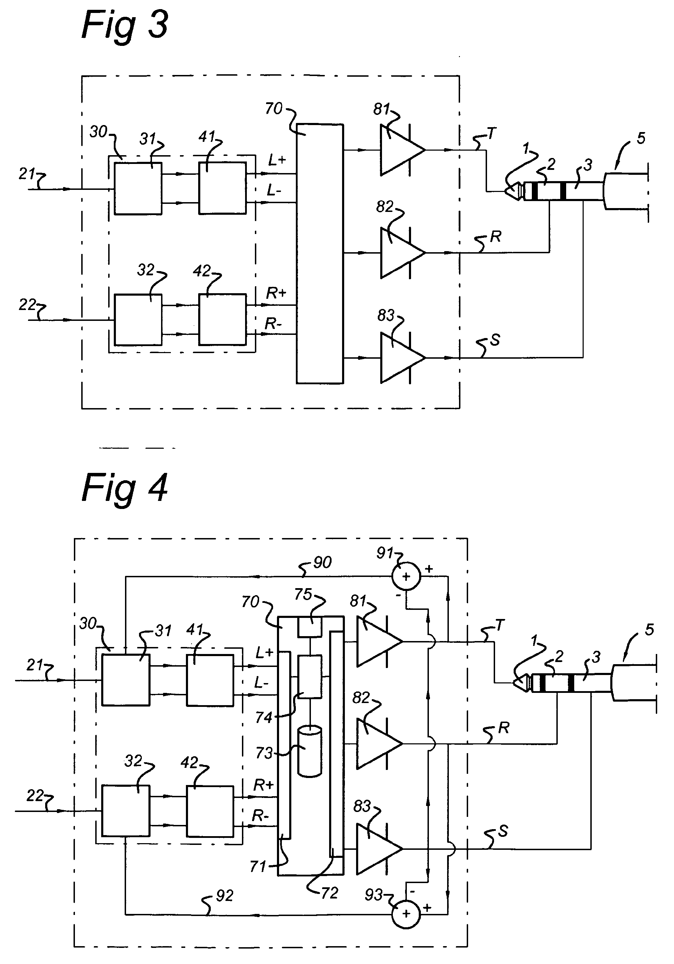

In Fig. 3, a four-way driving circuit 30 (e.g. a stereo bridge-tied-load class-D configuration) is schematically shown. The four-way driving circuit 30 may output four signals: L+, L-, R+ and R-, which are fed to a converter 70. The converter 70 transforms the four signals L+, L-, R+, R- into three signals, suitable to be fed to a three-way audio connector 5, such as described above with reference to Fig. 1.

The conversion as performed by the converter 70 is done in such a way that the three-way audio connector 5 is able to receive and process the output of the convertor 70 without further changes needed to the side of the three-way audio connector 5.

So, according to an embodiment there is provided a three-way audio driver arranged to produce a three-way drive signal for driving a first and a second speaker in response to an input signal 21, 22. The first and second speakers may be the speakers of an audio installation or head phones. The three-way audio driver being arranged to generate a first three-way drive signal component T for a first input of the first speaker, a second three-way drive signal component R for a first input of the second speaker, and a third three-way drive signal component S for a second input of the first speaker and a second input of the second speaker. The three-way audio driver comprises a four-way driving circuit and a convertor 70, the four-way driving circuit being arranged to generate a four-way drive signal L+, L-, R+, R- and the convertor 70 being arranged to receive the four-way drive signal L+, L-, R+, R- and convert the four-way drive signal L+, L-, R+, R- into a three-way drive signal R, T, S.

The four-way driver may be provided by a bridge-tied-load configuration. The bridge-tied-load configuration may comprise a sigma-delta convertor or a PWM-modulator. According to an example, the four-way driver may comprise a first and second loop filter 31, 32 and a first and second quantizer 41, 42, as already described above with reference to Fig. 2c. The four-way drive signal is a binary signal comprising;
- a first four-way drive signal component for the first input of the first speaker,
- a second four-way drive signal component for the second input of the first speaker,
- a third four-way drive signal component for the first input of the second speaker, and
- a fourth four-way drive signal component for the second input of the second speaker.

Such a three-way audio driver as provided here has the advantages of a four-way driving circuit as described above and is compatible with a three-way audio connector.

According to the state of the art, the third three-way drive signal component S is a constant voltage but unequal to the two possible levels of the other drive signal components T and R. In the proposed circuit, as will be explained in more detail below, all three drive signal components T, R and S are binary signals with the same two possible levels "0" and "V_{DD}". This overcomes the need for circuitry which generated a third voltage level and therefore improves efficiency.

In table 1 shown below, all possible output combinations of the four-way driving circuitry 30 are shown. The left column shows the possible combination of input signals 21, 22, representing the intended differential signals over the left and right speakers, the middle column shows the possible corresponding combinations of the four-way drive signals L+, L-, R+, R- as outputted by the four-way driving circuitry:

**Table 1**

| **Speaker** | | **Stereo BTL** | | | | | | |
|---|---|---|---|---|---|---|---|---|
| **Left** | **Right** | **L+** | **L-** | **R+** | **R-** | **Tip** | **Ring** | **Sleeve** |
| -1 | -1 | 0 | 1 | 0 | 1 | 0 | 0 | 1 |
| -1 | 0 | 0 | 1 | 0 | 0 | 0 | 1 | 1 |
| | | 0 | 1 | 1 | 0 | | | |
| -1 | +1 | | | | | missing code | | |
| | | | | | | | | |
| 0 | -1 | 0 | 0 | 0 | 1 | 1 | 0 | 1 |
| | | | | | | 0 | 0 | 0 |
| 0 | 0 | 0 | 0 | 0 | 0 | | or | |
| | | | | | | 1 | 1 | 1 |
| 0 | +1 | 0 | 0 | 1 | 0 | 0 | 1 | 0 |
| | | | | | | | | |
| +1 | -1 | 1 | 0 | 0 | 1 | missing code | | |
| | | | | | | | | |
| +1 | 0 | 1 | 0 | 0 | 0 | 1 | 0 | 0 |
| 1 | +1 | 1 | 0 | 1 | 0 | 1 | 1 | 0 |

The converter 70 receives a series of four codes from the four-way driving circuit 30 (L+, L-, R+, R-) and translates the series of four codes into a series of three (e.g. a TRS-signal) codes in accordance using a specific conversion table. The conversion table may for instance be stored in a memory device (not shown in figure 3), that is readable by the convertor 70.

The right column of table 1 shows the possible combination of binary three-way signals. The convertor 70 may use a conversion table as provided by the mid and right column of table 1 to convert incoming binary four-way drive signals into binary three-way drive signals. As can be seen, not all combinations of four-way drive signals can be uniquely transformed into a three-way drive signal, as a binary three-way drive signal can comprise less information than a binary four-way drive signal. This problem can be dealt with in different ways as will be explained in more detail below.

The converter 70 is connected to a first amplifier 81, a second amplifier 82 and a third amplifier 83. The first amplifier 81 may be connected to the first connector 1 of the three-way audio connector 5 (e.g. the Tip connection of a TRS-connector). The second amplifier 82 may be connected to the second connector 2 of the three-way audio connector 5 (e.g. the ring connection of a TRS-connector). The third amplifier 83 may be connected to the third connector 3 of the three-way audio connector 5 (e.g. the sleeve connection of a TRS-connector).

After the conversion, the convertor 70 generates a series of three signals, i.e. a first three-way audio drive signal component T (for the first connector 1), a second three-way audio drive signal component R (for the second connector 2) and a third three-way audio drive signal component S (for the third connector 3).

According to the prior art the third connector 3 was used as a common signal, usually ground. Thus, the three-way audio connector 5 or a device coupled to it, compared the first three-way audio signal component T to the third three-way signal audio component S and compared the second three-way signal audio component R to the third three-way signal audio component S. This functionality remains unchanged according to the embodiments.

The first, second and third amplifiers 81, 82, 83 have one end providing a positive voltage of V_{DD} and another end providing a zero voltage. The input of the first, second and third amplifier 81, 82, 83 is formed by the first, second and third three-way audio drive signal components respectively. The output signals of the first, second and third amplifiers 81, 82, 83 respectively are amplified first, second and third three-way audio drive signal components which may be provided to the first, second and third connectors 1, 2, 3 respectively.

The output signal of the first, second and third amplifiers 81, 82, 83 are signals with a value which alternates between ground and a voltage of V_{DD}.

As discussed in Fig. 2c, the bridge-tied-load class-D configuration (L+, L-, R+, R-) may provide a signal to a speaker with a changing value between the ground and a voltage supply V_{DD} (signal L+ and R+, L- and R-).

In order to simplify the interpretation, the voltage supply V_{DD} received by a positive terminal of the speaker (L+, R+) can be described by a value +1, the voltage supply V_{DD} received by a negative terminal of the speaker (L-, R-) can be described by a value -1, the ground voltage received by a terminal of the speaker (L+, R+, L-, R-) can be described by a value 0. Since L+ and R+ are connected to the positive terminal of the speaker and Land R- are connected to the negative terminal of the speaker, the differential signal over each speaker can be -1 (= 0 - 1), 0 (= 0 - 0 = 1 - 1) or +1 (= 1 ― 0).

In table 1, the left column shows that possible combinations of the left and right signals, the mid-column depicts the corresponding combinations of the L+, L-, R+, R-signals for a Bridge-Tied-Load configuration.

In addition, the value received by the speaker can be translated into a series of four codes as the corresponded bridge-tied-load (BTL) class-D configuration. For instance, if the left part and right part of the speaker (Left, Right) has a value of (Left = -1, Right = -1), the corresponding stereo BTL class-D configuration (L+, L-, R+, R-) can be translated into (L+ = 0, L- = 1, R+ = 0, R- = 1). Accordingly, a series of three proposal TRS (Tip, Ring, Sleeve) codes can be used to represent the stereo BTL class-D configuration (L+, L-, R+, R-). Thus, the code (L+ = 0, L- = 1, R+ = 0, R- = 1) in the stereo BTL class-D configuration (L+, L-, R+, R-) can be translated into a corresponding series of three individual codes (Tip = 0, Ring = 0, Sleeve = 1).

An example of the conversion table for the corresponding speaker value, BTL configuration value and TRS value is depicted in table 1. The left portion of the conversion table shows all the possible values of the speaker (Left, Right). It shows that there are nine possible values for the speaker. The portion in the middle of conversion table shows the corresponding translated stereo BTL class-D configuration (L+, L-, R+, R-). The right portion of the conversion table shows the corresponding translated series of three individual codes (Tip, Ring, Sleeve). It is a one-to-one conversion from the speaker (Left, Right) shown in the left portion of the conversion table into a series of three individual codes (Tip, Ring, Sleeve) shown in the right portion of the conversion table. The only exception is in the condition that both the left and the right part of speaker has the sign of zero (Left = 0, right = 0). In this condition, two series of three individual codes (Tip = 0, Ring = 0, Sleeve = 0) and (Tip = 1, Ring = 1, Sleeve = 1) can both represent the code of speaker (Left = 0, Right = 0). However, this conversion from the speaker (Left, Right) into a series of three individual codes (Tip, Ring, Sleeve), as depicted in table 1, is only correct in seven out of the nine possible conditions. The two missing code conditions are that the left speaker has the opposite sign as the right speaker: (Left = +1, Right = -1) or (Left = -1, Right = +1).

Based on the above, it is clear that for a plurality of combinations of four-way drive signals:
- a difference between the first three-way drive signal and the third three-way drive signal is an indication of a difference between the first four-way drive signal and the second four-way drive signal, and wherein
- a difference between the second three-way drive signal and the third three-way drive signal, is an indication of a difference between the third four-way drive signal and the fourth four-way drive signal.

It will be understood that the above can only apply for a number of combinations of four-way drive signals, but not to all combinations of four-way drive signals, as more information can be encoded in four signals than in three signals. This is indicated in Table 1 by the words 'missing code'.

Further below, different embodiments will be described how to deal with 'missing codes'.

The four-way driving circuitries 30, for instance embodied by a sigma-delta converter, may each comprise a loop filter 31 and a quantizer 41. The quantizer 41 generates an output which depends on the input it receives. In case
- input < negative threshold (e.g. - 0.5), the output is -1,
- negative threshold (e.g. - 0.5) < input < positive threshold (e.g. +0.5), the output is 0, and
- Input > positive threshold (e.g. +0.5), the output is +1.

Although not shown, Fig. 3 may comprise a feedback loop wherein signals L-, L+, R-, R+ are fed back to their respective loop filters 31 to monitor the digitalization process as performed by the loop filter 31. The functioning of such a feedback loop will be understood by a skilled person.

Fig. 4 shows similar circuitry as Fig. 3, but now comprising an alternative feedback loops 90 that provides feedback of the three way signal components R, T, S to the loop filters 31. The first feedback loop 90 provides a first feedback signal to the first loop filter 31. The second feedback loop 92 provides a second feedback signal to the second loop filter 31.

The first feedback signal is formed by a first subtractor 91, subtracting the third three-way signal component S from the first three-way signal component T. The second feedback signal is formed by a second subtractor 93, subtracting the third three-way signal component S from the second three-way signal component R.

Thus, the first and second loop filters 31 receive both a first and second feedback signal 90 respectively and also receive first and second input signal 21, 22 respectively.

According to the embodiment described with reference to Fig. 4, a more accurate and reliable feedback loop is provided, that may also take into account errors caused by the convertor 70 or the first, second and third amplifiers 81, 82, 83, for instance caused by fluctuations in the energy supply towards the first, second and third amplifiers 81, 82, 83.

### Time multiplexing

According to an embodiment, a time-multiplexing scheme is used.

In this scheme, the three-way signals (Tip, Ring, Sleeve) are time-multiplexed, i.e. replaced by two codes just after each other in a first and second time frame respectively. The new code can be represented as (T1, T2; R1, R2; S1, S2), each of them spends half the time of the original code. This extra freedom makes it possible to code all possible situations.

A similar circuitry as shown in Fig. 3 may be used, wherein the convertor 70 is also arranged to time-multiplex.

During the first time frame, the value of for instance the right channel is substantially zero (R1 and S 1 both having the same value) and the value of left channel may be +1, 0, or -1, by giving T1 and S1 a suitable value.

During the second time frame, the value of for instance the left channel is substantially zero (T2 and S2 both having the same value) and the value of right channel may be +1, 0, or -1, by giving R2 and S2 a suitable value.

An example of corresponding conversion table with time multiplexing TRS value is depicted in table 2.

**Table 2**

| **Speaker** | | **Stereo BTL** | | | | | | |
|---|---|---|---|---|---|---|---|---|
| **Left** | **Right** | **L+** | **L-** | **R+** | **R-** | **Tip** | **Ring** | **Sleeve** |
| -1 | -1 | 0 | 1 | 0 | 1 | 0,1 | 1,0 | 1,1 |
| -1 | 0 | 0 | 1 | 0 | 0 | 0,0 | 1,0 | 1,0 |
| -1 | +1 | 0 | 1 | 1 | 0 | 0,0 | 1,1 | 1,0 |
| 0 | -1 | 0 | 0 | 0 | 1 | 0,1 | 0,0 | 0,1 |
| 0 | 0 | 0 | 0 | 0 | 0 | 0,0 | 0,0 | 0,0 |
| 0 | +1 | 0 | 0 | 1 | 0 | 0,0 | 0,1 | 0,0 |
| +1 | -1 | 1 | 0 | 0 | 1 | 1,1 | 0,0 | 0,1 |
| +1 | 0 | 1 | 0 | 0 | 0 | 1,0 | 0,0 | 0,0 |
| +1 | +1 | 1 | 0 | 1 | 0 | 1,0 | 0,1 | 0,0 |

For instance, the first line of the table can be understood as follows:
- during the first time frame, the tip 1 receives a value of zero, where the sleeve 3 receives a value of one, thus resulting in a value of minus one for the left speaker,
- during the first time frame, the ring 2 receives a values of one, the sleeve 3 receives a value of one, thus resulting in a value of zero for the right speaker,
- during the second time frame, the tip 1 receives a value of one, where the sleeve 3 receives a value of one, thus resulting in a value of zero for the left speaker,
- during the second time frame, the ring 2 receives a value of zero, where the sleeve 3 receives a value of one, thus resulting in a value of minus one for the left speaker.

Thus, on average, the tip receives minus ½, and the ring receives minus ½. So, the volume of the audio signal is reduced by a factor 50%, all audio information is present in the time-multiplexed three-way audio signal.

It is well known for people skilled in the art that the conversion table is not limited to table 2. Alternative solution for conversion table is possible. For instance, the first time frame and second time frame may be swapped.

An important advantage is that all information is now present in the three-way audio signal.

### Error feedback

The alternative approach is called error feedback scheme. In this scheme, the missing code is simply replaced by a code for which at least one of the two speakers can have the correct value.

Error feedback of the sigma delta converter of the four-way driving circuits 30 may be used to compensate for the error of the other speaker. These embodiments may be applied to the any one of the embodiments described above, such as shown in Fig.'s 3 and 4.

In principle, this can also be done for an embodiment using a pulse-width modulator instead of a sigma delta converter.

According to this embodiment, the convertor 70 is arranged to decide on the values of the first, second and third three-way drive signals using a decision algorithm. This decision algorithm may be formed in many ways, examples of which will be provided below. Based on the above explanation, it will be understood in most cases, i.e. in which no missing code situation occurs, the conversion table as shown in table 1 may just be employed. A missing code situation occurs in case the four-way drive signal L+, L-, R+, R- equals 0, 1, 1, 0, or 1 , 0, 0, 1.

The two missing code situations will be explained in more detail below.

### 1) (Left, Right) = (-1, +1) → (L+, L-, R+, R-) = (0, 1, 1, 0,)

In the third row of table 1, it shows that the corresponding three-way drive signal (T,R,S) code for speaker code (Left, Right) = (-1, +1) is (Tip, Ring, Sleeve) = (0, 1, x), i.e. two possibilities for the three-way drive signal exist for (Left, Right) = (-1, +1), which are: (T, R S) = (0, 1, 1) or (0, 1, 0), which can be indicated by (0,1,x).

In the situation of (0, 1, 1), the left channel has the correct value of -1, but the right channel has the value of 0 instead of the intended value +1. In the situation of (0, 1, 0), the right channel has the correct value of+1, but the left channel has the value of 0 instead of the intended value -1.

### 2) (Left, Right) = (+1, -1) → (L+, L-, R+, R-) = (1, 0, 0, 1,)

In the seventh row of Table 9, it shows that the corresponding three-way drive signal (T, R, S) code for this speaker code (Left, Right) = (-1, +1) is: (T, R, S) = (1, 0, x), i.e. two possibilities for the three-way drive signals exist for (Left, Right) = +1, -1), which are (T, R, S) = (1, 0, 0) or (1, 0, 1)., which can be indicated by (1, 0, x)

In the situation of (1, 0, 0), the left channel has the correct value of +1, but the right channel has the value of 0 instead of the intended value -1. In the situation of (1, 0, 1), the right channel has the correct value of -1, but the left channel has the value of 0 instead of the intended value +1.

In those situations, the convertor 70 is arranged to generate a three-way drive signal R, T, S which equals 0,1,x or 1,0, x respectively. The convertor 70 is further arranged to recognize the two missing code situations and execute a decision algorithm to determine the value of x.

Different alternatives may be conceived for the decision algorithm, a few of which will be discussed below. The different decision algorithms are arranged to decide upon the value for the third three-way drive signal component S, i.e. the sleeve-signal for the missing codes in order to compensate the missing code.

According to a first possible decision algorithm, the decision algorithm is arranged to determine the value of x by copying a previous value of the third three-way drive signal component.

The convertor 70 is arranged to store for each conversion the value of the third three-way drive signal component S and re-use this value decision algorithm in a next conversion in case a missing code situation occurs.

Thus, when a missing code situation occurs the convertor 70 may for instance automatically reads the previous value of the third three-way drive signal component S (sleeve-signal) which has previously been stored in a memory and sends this value to the third amplifier 83.

As a result, the third three-way drive signal component S is determined in a semi-random way, thereby distributing the error evenly over the left and right channel.

By coping the previous value of the sleeve-signal the number of signal transitions is kept low.

According to a further alternative, the decision algorithm is arranged to determine the value of x by giving priority to the channel that needs it most. This can be done by comparing the absolute values as outputted by the respective loop filters 31, as shown in Fig.'s 3 and 4. The first loop filter 31 outputs a signal associated with the left signal and the second loop filter 31 outputs a signal associated with the right signal. The channel with the maximum absolute value is given priority.

The loop filter 31 with the highest absolute output is used to determine the value of third three-way drive signal component S. For the channel (L or R) that is given the correct value for the third three-way drive signal component S, the output of the loop filter 31 will change towards zero, for the other channel the output will change in a direction away from zero.

The output of the loop filer 31 may be a differential signal (in which case the absolute value is determined by the difference between the signals) or a single-ended signal (one connection).

It will be understood that the channel changing away from zero introduces the risk of getting instable or clipping. Therefore, the channel with the maximum absolute value can be giving priority to change the output of the respective loop filter towards zero, thereby reducing the risk of instability or clipping.

Thus, there is provided an embodiment wherein the four-way driving circuit 30 comprises a first and second loop filter 31 associated with a first and second channel, being the left and right channels. The first loop filter 31 being arranged to generate a first output and the second loop filter 31 being arranged to generate a second output. The first and second outputs are forwarded to corresponding first and second quantizers 41. The decision algorithm is arranged to determine which one of the first and second output has the highest absolute value. The channel with the highest output of the loop filter is given priority, i.e. is used as a basis to determine the value of x.

According to such an embodiment, there is provided a method wherein the decision algorithm determines the value of x by
- determining an absolute value of a first output of a first loop filter associated with a first channel,
- determining an absolute value of a second output of a second loop filter associated with a second channel,
- determining which one of the first output and the second output has the highest absolute value,
- determine the value of x in accordance with the channel corresponding with the highest output.

According to a further alternative for the decision algorithm, the decision algorithm is arranged to determine the value of x, i.e. the third three-way signal drive signal component S, such that alternatively:
- a difference between the first three-way drive signal and the third three-way drive signal is an indication of a difference between the first four-way drive signal and the second four-way drive signal, and
- a difference between the second three-way drive signal and the third three-way drive signal, is an indication of a difference between the third four-way drive signal and the fourth four-way drive signal.

In other words, the priority is given to the left and right channel in an alternating way, for instance: the first missing code will give priority to the left channel, the next to the right channel, and so on.

It will be understood that the convertor 70 may be arranged as a piece of hardware dedicated for performing one or more of the above described embodiments.

Alternatively, the convertor 70 may be arranged as a computer device, comprising an input unit 71, an output unit 72, a memory 73 and a processor 74. This is schematically shown in Fig. 4. The processor 74 may be arranged to communicate with the input unit 71, the output unit 72 and the memory 73.The input unit 71 may be arranged to receive the four-way drive signals. The output unit 72 may be arranged to output the three-way drive signals. The memory device 73 may comprise programming lines, i.e. data and instructions.

The processor 74 may be arranged to read and execute the programming lines from the memory 74, to perform the methods as described. Furthermore, the processor 74 may comprise an interface 75 to receive instructions from a user and or a remote computer device.

Thus there is provided a computer program product comprising data and instructions that can be loaded by a computer device, allowing said computer device to perform any of the methods described above. Also provided is a computer readable medium provided with such a computer program product, for instance formed by memory.

It is to be understood that the invention is limited by the annexed claims and its technical equivalents only. In this document and in its claims, the verb "to comprise" and its conjugations are used in their non-limiting sense to mean that items following the word are included, without excluding items not specifically mentioned. In addition, reference to an element by the indefinite article "a" or "an" does not exclude the possibility that more than one of the element is present, unless the context clearly requires that there be one and only one of the elements. The indefinite article "a" or "an" thus usually means "at least one".

### REFERENCES

[1] MAX9820, "DirectDrive Headphone Amplifier with External Gain," Maxim product datasheet, 2009
[2] T. Doy, "Single Supply Headphone Driver/Charge Pump Combination," U.S. Patent 7,061,327 B2, June 13, 2006
[3] TPA6140A2, "Class-G Directpathtm Stereo Headphone Amplifier with I2C Volume Control," Texas Instruments product datasheet, March 2009
[4] S.-B. You, "Method, Apparatus and System for Reducing DC Coupling Capacitance at Switching Amplifier," U.S. Patent 7,602,245 B2, October 13,
[5] NE58633, "Noise reduction class-D headphone driver amplifier," NXP product datasheet, rev. 02, May 25, 2009
[6] K. Lee, et al., "A 0.8 V, 2.6 mW, 88 dB Dual-Channel Audio Delta-Sigma D/A Converter With Headphone Driver," IEEE J. Solid-State Circuits, vol. 44, no. 3, pp. 916-927, March 2009
[7] W. T.-F. Chen, et al., "Modulation Scheme for Filterless Switching Amplifiers," U.S. Patent 6,211,728 B1, April 3, 2001
[8] M. W. Kruiskamp, "Digital Input Class-D amplifier," U.S. Patent 6,646,502 B1, November 11, 2003
[9] C.-C. Yang, "Class-D Audio Amplifier with Half-Swing Pulse-Width-Modulation," U.S. Patent 7,339,425 B2, March 4, 2008
[10] M. Corsi, "Concept and Method to Enable Filterless, Efficient Operation of Class-D Amplifiers," U.S. Patent 6,262,632 B1, July 17, 2001
[11] Danielson, "Time Division Multiplexed PMW Amplifier", U.S. Patent 6,552,607 B1, April 22, 2003.

## Claims

1. Three-way audio driver arranged to produce a three-way drive signal for driving a first and a second speaker in response to an input signal (21, 22), the three-way audio driver being arranged to generate a first three-way drive signal component for a first input of the first speaker, a second three-way drive signal component for a first input of the second speaker, and a third three-way drive signal component for a second input of the first speaker and a second input of the second speaker,
the three-way audio driver comprises a four-way driving circuit and a converter (70), the four-way driving circuit being arranged to generate a four-way drive signal and the converter (70) being arranged to receive the four-way drive signal and convert the four-way drive signal into a three-way drive signal
**characterized in that** the convertor (70) is arranged as follows:
- in case the four-way drive signal L+, L-, R+, R- equals 0, 1, 1, 0, a three-way drive signal R, T, S is generated which equals 0, 1, x, and
- in case the four-way drive signal L+, L-, R+, R- equals 1, 0, 0, 1 a three-way drive signal R, T, S is generated which equals 1, 0, x,
wherein the convertor is further arranged to execute a decision algorithm to determine the value of x.

2. Three-way audio driver according to claim 1, wherein the four-way driver is provided by a bridge-tied-load configuration.

3. Three-way audio driver according to any one of the preceding claims, wherein the four-way drive signal is a binary signal comprising
- a first four-way drive signal component for the first input of the first speaker,
- a second four-way drive signal component for the second input of the first speaker,
- a third -way drive signal component for the first input of the second speaker, and
- a fourth four-way drive signal component for the second input of the second speaker.

4. Three-way audio driver according to any one of the preceding claims, wherein the three-way drive signal components are binary signals.

5. Three-way audio driver according to any one of the preceding claims, wherein for a group of combinations of four-way drive signals:
- a difference between the first three-way drive signal and the third three-way drive signal is an indication of a difference between the first four-way drive signal and the second four-way drive signal, and wherein
- a difference between the second three-way drive signal and the third three-way drive signal, is an indication of a difference between the third four-way drive signal and the fourth four-way drive signal.

6. Three-way audio-driver according to any one of the preceding claims, wherein the converter (70) uses a conversion table, such as:
| **Four way drive signal** | **Three way drive signal** |
|---|---|
| 0 1 0 1 | 0 0 1 |
| 0 1 0 0 | 0 1 1 |
| 0 1 1 0 | 0 1 x (missing code) |
| 0 0 0 1 | 1 0 1 |
| 0 0 0 0 | 0 0 0 or 1 1 1 |
| 0 0 1 0 | 0 1 0 |
| 1 0 0 1 | 1 0 x (missing code) |
| 1 0 0 0 | 1 0 0 |
| 1 0 1 0 | 1 1 0 |

7. Three-way audio driver according to any one of the preceding claims, wherein the decision algorithm is arranged to determine the value of x by copying a previous value of the third three-way drive signal component.

8. Three-way audio driver according to any one of the preceding claims, wherein the four-way driving circuit (30) comprises a first and second loop filter (31) associated with a first and second channel,
the first loop filter (31) being arranged to generate a first output and the second loop filter (31) being arranged to generate a second output,
whereby the decision algorithm is arranged to determine which one of the first and second output has the highest absolute value and to determine the value of x in accordance with the channel corresponding with the highest output.

9. Three-way audio driver according to any one of the preceding claims, wherein the decision algorithm is arranged to determine the value of x such that alternatively:
- a difference between the first three-way drive signal and the third three-way drive signal is an indication of a difference between the first four-way drive signal and the second four-way drive signal, and
- a difference between the second three-way drive signal and the third three-way drive signal, is an indication of a difference between the third four-way drive signal and the fourth four-way drive signal.

10. Method of generating a three-way audio drive signal for driving a first and a second speaker in response to an input signal (21, 22), the method comprising:
a) receiving an input signal (21, 22),
b) generating a four-way drive signal based on the received input signal (21, 22),
c) converting the generated four-way drive signal into a three-way drive signal comprising a first three-way drive signal component for a first input of the first speaker, a second three-way drive signal component for a first input of the second speaker, and a third three-way drive signal component for a second input of the first speaker and a second input of the second speaker, wherein c) comprises:
- in case the four-way drive signal L+, L-, R+, R- equals 0, 1, 1, 0, a three-way drive signal R, T, S is generated which equals 0, 1, x, and
- in case the four-way drive signal L+, L-, R+, R- equals 1, 0, 0, 1 a three-way drive signal R, T, S is generated which equals 1, 0, x, and
executing a decision algorithm to determine the value of x.

11. Method according to claim 10, wherein the decision algorithm determines the value of x by copying a previous value of the third three-way drive signal component.

12. Method according to claim 10, wherein the decision algorithm determines the value ofx by
- determining an absolute value of a first output of a first loop filter associated with a first channel,
- determining an absolute value of a second output of a second loop filter associated with a second channel,
- determining which one of the first output and the second output has the highest absolute value,
- determine the value of x in accordance with the channel corresponding with the highest output.

13. Method according to claim 10, wherein the decision algorithm determines the value of x such that alternatively:
- a difference between the first three-way drive signal and the third three-way drive signal is an indication of a difference between the first four-way drive signal and the second four-way drive signal, and
- a difference between the second three-way drive signal and the third three-way drive signal, is an indication of a difference between the third four-way drive signal and the fourth four-way drive signal.

14. Computer program product comprising data and instructions that can be loaded by a computer device, allowing said computer device to perform any of the methods according to claims 10 - 13.

15. Computer readable medium provided with a computer program product according to claim 14.

16. Computer device (70) arranged to perform any one of the methods according claims 10 - 13.

## Patentansprüche

1. Dreiwege-Audio-Ansteuervorrichtung, die so eingerichtet ist, dass sie ein Dreiwege-Ansteuersignal zum Ansteuern eines ersten und eines zweiten Lautsprechers in Reaktion auf ein Eingangssignal (21, 22) erzeugt, wobei die Dreiwege-Audio-Ansteuereinrichtung so eingerichtet ist, dass sie eine erste Dreiwege-Ansteuersignal-Komponente für einen ersten Eingang des ersten Lautsprechers, eine zweite Dreiwege-Ansteuersignal-Komponente für einen ersten Eingang des zweiten Lautsprechers sowie eine dritte Dreiwege-Ansteuersignal-Komponente für einen zweiten Eingang des ersten Lautsprechers und einen zweiten Eingang des zweiten Lautsprechers generiert,
wobei die Dreiwege-Audio-Ansteuervorrichtung eine Vierwege-Ansteuerschaltung sowie einen Wandler (70) umfasst, die Vierwege-Ansteuerschaltung so eingerichtet ist, dass sie ein Vierwege-Ansteuersignal generiert, und der Wandler (70) so eingerichtet ist, dass er das Vierwege-Ansteuersignal empfängt und das Vierwege-Ansteuersignal in ein Dreiwege-Ansteuersignal umwandelt,
**dadurch gekennzeichnet, dass** der Wandler (70) wie folgt eingerichtet ist:
- wenn das Vierwege-Ansteuersignal L+, L-, R+, R- 0, 1, 1, 0 entspricht, ein Dreiwege-Ansteuersignal R, T, S generiert wird, das 0, 1, x entspricht, und
- wenn das Vierwege-Ansteuersignal L+, L-, R+, R- 1, 0, 0, 1 entspricht, ein Dreiwege-Ansteuersignal R, T, S generiert wird, das 1, 0, x entspricht,
wobei der Wandler des Weiteren so eingerichtet ist, dass er einen Entscheidungs-Algorithmus ausführt, um den Wert von x zu bestimmen.

2. Dreiwege-Audio-Ansteuervorrichtung nach Anspruch 1, wobei die Vierwege-Ansteuervorrichtung von einer BTL-Konfiguration (bridge-tied-load configuration) gebildet wird.

3. Dreiwege-Audio-Ansteuervorrichtung nach einem der vorangehenden Ansprüche, wobei das Vierwege-Ansteuersignal ein binäres Signal ist, das umfasst:
- eine erste Vierwege- Ansteuersignal-Komponente für den ersten Eingang des ersten Lautsprechers,
- eine zweite Vierwege-Ansteuersignal-Komponente für den zweiten Eingang des ersten Lautsprechers,
- eine dritte Vierwege-Ansteuersignal-Komponente für den ersten Eingang des zweiten Lautsprechers, und
- eine vierte Vierwege-Ansteuersignal-Komponente für den zweiten Eingang des zweiten Lautsprechers.

4. Dreiwege-Audio-Ansteuervorrichtung nach einem der vorangehenden Ansprüche, wobei die Dreiwege-Ansteuersignal-Komponenten binäre Signale sind.

5. Dreiwege-Ansteuervorrichtung nach einem der vorangehenden Ansprüche, wobei für eine Gruppe von Kombinationen von Vierwege-Ansteuersignalen:
- eine Differenz zwischen dem ersten Dreiwege-Ansteuersignal und dem dritten Dreiwege-Ansteuersignal ein Hinweis auf eine Differenz zwischen dem ersten Vierwege-Ansteuersignal und dem zweiten Vierwege-Ansteuersignal ist, und
- eine Differenz zwischen dem zweiten Dreiwege-Ansteuersignal und dem dritten Dreiwege-Ansteuersignal ein Hinweis auf eine Differenz zwischen dem dritten Vierwege-Ansteuersignal und dem vierten Vierwege-Ansteuersignal ist.

6. Dreiwege-Audio-Ansteuervorrichtung nach einem der vorangehenden Ansprüche, wobei der Wandler (70) eine Umwandlungstabelle wie die folgende verwendet:
| **Vierwege-Ansteuersignal** | **Dreiwege-Ansteuersignal** |
|---|---|
| 0101 | 001 |
| 0100 | 011 |
| 0110 | 01 x (fehlender Code) |
| 0001 | 101 |
| 0000 | 000 oder 111 |
| 0010 | 010 |
| 1001 | 10 x (fehlender Code) |
| 1000 | 100 |
| 1010 | 110 |

7. Dreiwege-Audio-Ansteuervorrichtung nach einem der vorangehenden Ansprüche, wobei der Entscheidungs-Algorithmus so eingerichtet ist, dass er den Wert von x bestimmt, indem er einen vorhergehenden Wert der dritten Dreiwege-Ansteuersignal-Komponente kopiert.

8. Dreiwege-Audio-Ansteuervorrichtung nach einem der vorangehenden Ansprüche, wobei die Vierwege-Ansteuerschaltung (30) ein erstes und ein zweites Schleifenfilter (31) umfasst, die mit einem ersten und einem zweiten Kanal verbunden sind,
das erste Schleifenfilter (31) so eingerichtet ist, dass es einen ersten Ausgang generiert, und das zweite Schleifenfilter (31) so eingerichtet ist, dass es einen zweiten Ausgang generiert,
und der Entscheidungs-Algorithmus so eingerichtet ist, dass er bestimmt, welcher von dem ersten und dem zweiten Ausgang den höchsten Absolutwert hat, und den Wert von x entsprechend dem Kanal bestimmt, der dem höchsten Ausgang entspricht.

9. Dreiwege-Audio-Ansteuervorrichtung nach einem der vorangehenden Ansprüche, wobei der Entscheidungs-Algorithmus so eingerichtet ist, dass er den Wert von x so bestimmt, dass alternativ:
- eine Differenz zwischen dem ersten Dreiwege-Ansteuersignal und dem dritten Dreiwege-Ansteuersignal ein Hinweis auf eine Differenz zwischen dem ersten Vierwege-Ansteuersignal und dem zweiten Vierwege-Ansteuersignal ist, und
- eine Differenz zwischen dem zweiten Dreiwege-Ansteuersignal und dem dritten Dreiwege-Ansteuersignal ein Hinweis auf eine Differenz zwischen dem dritten Vierwege-Ansteuersignal und dem vierten Vierwege-Ansteuersignal ist.

10. Verfahren zum Generieren eines Dreiwege-Audio-Ansteuersignals zum Ansteuern eines ersten und eines zweiten Lautsprechers in Reaktion auf ein Eingangssignal (21, 22), wobei das Verfahren umfasst:
a) Empfangen eines Eingangssignals (21, 22),
b) Generieren eines Vierwege-Ansteuersignals auf Basis des empfangenen Eingangssignals (21, 22),
c) Umwandeln des generierten Vierwege-Ansteuersignals in ein Dreiwege-Ansteuersignal, das eine erste Dreiwege-Ansteuersignal-Komponente für einen ersten Eingang des ersten Lautsprechers, eine zweite Dreiwege-Ansteuersignal-Komponente für einen ersten Eingang des zweiten Lautsprechers sowie eine dritte Dreiwege-Ansteuersignal-Komponente für einen zweiten Eingang des ersten Lautsprechers und einen zweiten Eingang des zweiten Lautsprechers umfasst, wobei c) umfasst:
- wenn das Vierwege-Ansteuersignal L+, L-, R+, R- 0, 1, 1, 0 entspricht, ein Dreiwege-Ansteuersignal R, T, S generiert wird, das 0, 1, x entspricht, und
- wenn das Vierwege-Ansteuersignal L+, L-, R+, R- 1, 0, 0, 1 entspricht, ein Dreiwege-Ansteuersignal R, T, S generiert wird, das 1, 0, x entspricht, und
Ausführen eines Entscheidungs-Algorithmus, um den Wert von x zu bestimmen.

11. Verfahren nach Anspruch 10, wobei der Entscheidungs-Algorithmus den Wert von x durch Kopieren eines vorhergehenden Wertes der Dreiwege-Ansteuersignal-Komponente bestimmt.

12. Verfahren nach Anspruch 10, wobei der Entscheidungs-Algorithmus den Wert von x bestimmt, indem er
- einen Absolutwert eines ersten Ausgangs eines ersten Schleifenfilters bestimmt, das mit einem ersten Kanal verbunden ist,
- einen Absolutwert eines zweiten Ausgangs eines zweiten Schleifenfilters bestimmt, das mit einem zweiten Kanal verbunden ist,
- bestimmt, welcher von dem ersten Ausgang und dem zweiten Ausgang den höchsten Absolutwert hat,
- den Wert von x entsprechend dem Kanal bestimmt, der dem höchsten Ausgang entspricht.

13. Verfahren nach Anspruch 10, wobei der Entscheidungs-Algorithmus den Wert von x so bestimmt, dass alternativ:
- eine Differenz zwischen dem ersten Dreiwege-Ansteuersignal und dem dritten Dreiwege-Ansteuersignal ein Hinweis auf eine Differenz zwischen dem ersten Vierwege-Ansteuersignal und dem zweiten Vierwege-Ansteuersignal ist, und
- eine Differenz zwischen dem zweiten Dreiwege-Ansteuersignal und dem dritten Dreiwege-Ansteuersignal ein Hinweis auf eine Differenz zwischen dem dritten Vierwege-Ansteuersignal und dem vierten Vierwege-Ansteuersignal ist.

14. Computerprogrammerzeugnis, das Daten und Befehle umfasst, die von einer Computervorrichtung geladen werden können und es der Computervorrichtung gestatten, eines der Verfahren nach den Ansprüchen 10 - 13 durchzuführen.

15. Computerlesbares Medium, das mit einem Computerprogrammerzeugnis nach Anspruch 14 versehen ist.

16. Computervorrichtung (70), die zum Durchführen eines der Verfahren nach den Ansprüchen 10 - 13 eingerichtet ist.

## Revendications

1. Circuit de commande audio à trois voies agencé de manière à produire un signal de commande à trois voies destiné à commander un premier haut-parleur et un second haut-parleur en réponse à un signal d'entrée (21, 22), le circuit de commande audio à trois voies étant agencé de manière à générer une première composante de signal de commande à trois voies pour une première entrée du premier haut-parleur, une deuxième composante de signal de commande à trois voies pour une première entrée du second haut-parleur, et une troisième composante de signal de commande à trois voies pour une seconde entrée du premier haut-parleur et une seconde entrée du second haut-parleur ;
le circuit de commande audio à trois voies comporte un circuit de commande à quatre voies et un convertisseur (70), le circuit de commande à quatre voies étant agencé de manière à générer un signal de commande à quatre voies et le convertisseur (70) étant agencé de manière à recevoir le signal de commande à quatre voies et à convertir le signal de commande à quatre voies en un signal de commande à trois voies ;
**caractérisé en ce que** le convertisseur (70) est agencé comme suit :
- dans le cas où le signal de commande à quatre voies L+, L-, R+, R- est égal à 0, 1, 1, 0, un signal de commande à trois voies R, T, S est généré qui est égal à 0, 1, x ; et
- dans le cas où le signal de commande à quatre voies L+, L-, R+, R- est égal à 1, 0, 0, 1, un signal de commande à trois voies R, T, S est généré qui est égal à 1, 0, x ;
dans lequel le convertisseur est en outre agencé de manière à exécuter un algorithme de décision en vue de déterminer la valeur de x.

2. Circuit de commande audio à trois voies selon la revendication 1, dans lequel le circuit de commande à quatre voies est fourni par une configuration à charge montée en pont.

3. Circuit de commande audio à trois voies selon l'une quelconque des revendications précédentes, dans lequel le signal de commande à quatre voies correspond à un signal binaire comprenant :
- une première composante de signal de commande à quatre voies pour la première entrée du premier haut-parleur ;
- une deuxième composante de signal de commande à quatre voies pour la seconde entrée du premier haut-parleur ;
- une troisième composante de signal de commande à quatre voies pour la première entrée du second haut-parleur ; et
- une quatrième composante de signal de commande à quatre voies pour la seconde entrée du second haut-parleur.

4. Circuit de commande audio à trois voies selon l'une quelconque des revendications précédentes, dans lequel les composantes de signal de commande à trois voies correspondent à des signaux binaires.

5. Circuit de commande audio à trois voies selon l'une quelconque des revendications précédentes, dans lequel, pour un groupe de combinaisons de signaux de commande à quatre voies :
- une différence entre le premier signal de commande à trois voies et le troisième signal de commande à trois voies constitue une indication d'une différence entre le premier signal de commande à quatre voies et le deuxième signal de commande à quatre voies, et dans lequel :
- une différence entre le deuxième signal de commande à trois voies et le troisième signal de commande à trois voies constitue une indication d'une différence entre le troisième signal de commande à quatre voies et le quatrième signal de commande à quatre voies.

6. Circuit de commande audio à trois voies selon l'une quelconque des revendications précédentes, dans lequel le convertisseur (70) utilise une table de conversion, telle que :
| **Signal de commande à quatre voies** | **Signal de commande à trois voies** |
|---|---|
| 0101 | 001 |
| 0100 | 011 |
| 0110 | 01 x (code manquant) |
| 0001 | 101 |
| 0000 | 000 ou 111 |
| 0010 | 010 |
| 1001 | 10 x (code manquant) |
| 1000 | 100 |
| 1010 | 110 |

7. Circuit de commande audio à trois voies selon l'une quelconque des revendications précédentes, dans lequel l'algorithme de décision est agencé de manière à déterminer la valeur de x en copiant une valeur précédente de la troisième composante de signal de commande à trois voies.

8. Circuit de commande audio à trois voies selon l'une quelconque des revendications précédentes, dans lequel le circuit de commande à quatre voies (30) comprend un premier filtre à boucle et un second filtre à boucle (31) associés à un premier canal et un second canal ;
le premier filtre à boucle (31) étant agencé de manière à générer une première sortie et le second filtre à boucle (31) étant agencé de manière à générer une seconde sortie ;
par lequel l'algorithme de décision est agencé de manière à déterminer laquelle des première et seconde sorties présente la valeur absolue la plus élevée, et à déterminer la valeur de x selon le canal correspondant à la sortie la plus élevée.

9. Circuit de commande audio à trois voies selon l'une quelconque des revendications précédentes, dans lequel l'algorithme de décision est agencé de manière à déterminer la valeur de x, de sorte que, alternativement :
- une différence entre le premier signal de commande à trois voies et le troisième signal de commande à trois voies constitue une indication d'une différence entre le premier signal de commande à quatre voies et le deuxième signal de commande à quatre voies ; et
- une différence entre le deuxième signal de commande à trois voies et le troisième signal de commande à trois voies constitue une indication d'une différence entre le troisième signal de commande à quatre voies et le quatrième signal de commande à quatre voies.

10. Procédé de génération d'un signal de commande audio à trois voies destiné à commander un premier haut-parleur et un second haut-parleur en réponse à un signal d'entrée (21, 22), le procédé consistant à :
a) recevoir un signal d'entrée (21, 22) ;
b) générer un signal de commande à quatre voies sur la base du signal d'entrée reçu (21, 22) ;
c) convertir le signal de commande à quatre voies généré en un signal de commande à trois voies comprenant une première composante de signal de commande à trois voies pour une première entrée du premier haut-parleur, une deuxième composante de signal de commande à trois voies pour une première entrée du second haut-parleur, et une troisième composante de signal de commande à trois voies pour une seconde entrée du premier haut-parleur et une seconde entrée du second haut-parleur, dans lequel l'étape c) comprend :
- dans le cas où le signal de commande à quatre voies L+, L-, R+, R- est égal à 0, 1, 1, 0, un signal de commande à trois voies R, T, S est généré qui est égal à 0, 1, x ; et
- dans le cas où le signal de commande à quatre voies L+, L-, R+, R- est égal à 1, 0, 0, 1, un signal de commande à trois voies R, T, S est généré qui est égal à 1, 0, x ; et consiste à :
exécuter un algorithme de décision en vue de déterminer la valeur de x.

11. Procédé selon la revendication 10, dans lequel l'algorithme de décision détermine la valeur de x en copiant une valeur précédente de la troisième composante de signal de commande à trois voies.

12. Procédé selon la revendication 10, dans lequel l'algorithme de décision détermine la valeur de x :
- en déterminant une valeur absolue d'une première sortie d'un premier filtre à boucle associé à un premier canal ;
- en déterminant une valeur absolue d'une seconde sortie d'un second filtre à boucle associé à un second canal ;
- en déterminant laquelle de la première sortie et de la seconde sortie présente la valeur absolue la plus élevée ;
- en déterminant la valeur de x selon le canal correspondant à la sortie la plus élevée.

13. Procédé selon la revendication 10, dans lequel l'algorithme de décision détermine la valeur de x de sorte que, alternativement :
- une différence entre le premier signal de commande à trois voies et le troisième signal de commande à trois voies constitue une indication d'une différence entre le premier signal de commande à quatre voies et le deuxième signal de commande à quatre voies ; et
- une différence entre le deuxième signal de commande à trois voies et le troisième signal de commande à trois voies constitue une indication d'une différence entre le troisième signal de commande à quatre voies et le quatrième signal de commande à quatre voies.

14. Produit-programme informatique comprenant des données et des instructions qui peuvent être chargées par un dispositif informatique, permettant audit dispositif informatique de mettre en oeuvre l'un quelconque des procédés selon les revendications 10 à 13.

15. Support lisible par ordinateur doté d'un produit-programme informatique selon la revendication 14.

16. Dispositif informatique (70) agencé de manière à mettre en oeuvre l'un quelconque des procédés selon les revendications 10 à 13.
